# EUROPEAN PATENT APPLICATION

(11) **EP 4 811 423 A1**
(43) Date of publication of application: **23.09.2026**
(21) Application number: 25164036.3
(22) Date of filing: 17.03.2025
(51) Int. Cl.: H01L 21/67

(54) **METHOD OF BONDING SUBSTRATES AND APPARATUS FOR BONDING SUBSTRATES**

(71) Applicant: ASML Netherlands B.V., 5500 AH Veldhoven (NL)
(72) Inventor: BUIJS, Robin, Daniel, 5500 AH Veldhoven (NL); TUMER, Can, 5500 AH Veldhoven (NL)
(74) Representative: ASML Netherlands B.V.

(57) **Abstract**

The present disclosure relates to a method of bonding a first substrate to a second substrate. The method may comprise, while bringing a bonding surface of the first substrate into contact with a bonding surface of the second substrate, driving at least one vibrational mode of the first substrate to modify a speed of propagation of a bond front. The present disclosure also relates to another method of bonding a first substrate and a second substrate. The method may comprise, while bringing a bonding surface of the first substrate into contact with a bonding surface of the second substrate, generating a wave configured to interact with a bond front to modify a speed of propagation of the bond front. The present disclosure also relates to other, related methods, and apparatuses for performing the methods.

## Description

### FIELD OF INVENTION

The present invention relates to methods of bonding a first substrate and a second substrate, a method of determining at least one operating frequency for driving at least one vibrational mode in a first substrate during a bonding process, and apparatuses for bonding a first substrate and a second substrate.

### BACKGROUND

In the manufacture of integrated circuits (ICs), circuit features are formed on/in semiconductor substrates. To form circuit features on/in a semiconductor substrate, various processes may be performed such as: depositing a layer of photoresist on a surface on the semiconductor substrate; imparting of a pattern to the layer of photoresist using lithography; etching material away from the semiconductor substrate or layers deposited thereon, in accordance with the pattern imparted to the layer of photoresist during lithography; and modifying characteristics of the semiconductor substrate or the layers formed thereon, (e.g. through oxidation, doping, ion implantation, etc.).

To form some types of device, one semiconductor substrate (which may have circuit features formed thereon) may be bonded with another semiconductor substrate (which may also have circuit features formed therein/thereon). Bonding processes include die-to-die, die-to-wafer and wafer-to-wafer bonding processes. Wafer-to-wafer bonding involves whole wafers being permanently bonded together prior to dicing. In die-to-die bonding, an individual die (which may originate from a wafer that has been diced) may be bonded to another individual die (which may also originate from a wafer that has been diced. In die-to-wafer bonding, an individual die (which may originate from a wafer that has been diced) may be bonded to a whole wafer. In bonding process, a high accuracy and a high throughput are important.

During typical bonding methods, distortions may be formed in the semiconductor substrates that are being bonded together. For example, distortions may be formed by the propagation of a bond front from a centrally-located bond initiation point to the edge of the substrate. In particular, distortions may be formed where the bond front does not propagate uniformly. These distortions may have a negative effect on the product that comprises the bonded semiconductor substrates. For example, distortion may result in misalignment of the semiconductor substrates (overlay error), which may mean that the product does not function as intended. This may mean that yield is reduced, because a significant number of products are scrapped.

### SUMMARY OF THE INVENTION

An aim of the invention is to provide a method of bonding two substrates which reduces distortion to the substrates.

An aspect of the present disclosure is a method of bonding a first substrate and a second substrate. The method may comprise, while bringing a bonding surface of the first substrate into contact with a bonding surface of the second substrate, driving at least one vibrational mode of the first substrate to modify a speed of propagation of a bond front.

Another aspect of the present disclosure is a method of determining at least one operating frequency for driving at least one vibrational mode in a first substrate during a bonding process. The bonding process may comprise bonding the first substrate and a second substrate. The method may comprise obtaining, as a function of position relative to the first substrate, the speed at which a bond front propagates during the bonding of the first substrate and the second substrate, or an indication thereof. The method may further comprise selecting at least one vibrational mode of the first substrate based on the speed at which the bond front propagates as a function of position. The method may further comprise determining at least one operating frequency that drives the selected at least one vibrational mode in the first substrate.

Another aspect of the present disclosure is a method of bonding a first substrate and a second substrate. The method may comprise, while bringing a bonding surface of the first substrate into contact with a bonding surface of the second substrate, generating a wave in the first substrate or a medium around the first substrate, wherein the wave is configured to interact with a bond front to modify a speed of propagation of the bond front.

Another aspect of the present disclosure is an apparatus for bonding a first substrate and a second substrate. The apparatus may comprise a clamp for clamping the first substrate, and an extensible pin configured to apply a force to a rear surface of the first substrate to cause a bonding surface of the first substrate to make contact with a bonding surface of the second substrate. The apparatus may further comprise a plurality of mechanical transducers each configured to apply an oscillatory contact force to the first substrate to drive at least one vibration mode of the first substrate.

Another aspect of the present disclosure is an apparatus for bonding a first substrate and a second substrate. The apparatus may comprise a clamp for clamping the first substrate, and an extensible pin configured to apply a force to a rear surface of the first substrate to cause a bonding surface of the first substrate to make contact with a bonding surface of the second substrate. The apparatus may further comprise an acoustic transducer. The acoustic transducer may be s configured to induce a mechanical vibration in the first substrate acoustically, and/or to generate a wave in a medium between the first substrate and the second substrate during the bonding of the first substrate and the second substrate.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings which are briefly described below.
Figure 1 depicts a lithographic apparatus together with other apparatuses forming a production facility for semiconductor devices.
Figure 2 is a diagram describing a present method of manufacturing integrated devices which utilizes the bonding of substrates.
Figure 3 schematically depicts a hybrid bonding process.
Figure 4A depicts the steps of a conventional bonding method.
Figure 4B depicts the alignment of metallic portions of the two substrates at various stages of the conventional bonding method.
Figure 5 depicts a plot of the overlay error across a substrate that has been bonded to another substrate.
Figure 6 depicts several vibration modes of a circular membrane.
Figure 7 depicts a bonding apparatus in accordance with an embodiment.
Figures 8A depicts a bonding apparatus in accordance with an embodiment.
Figure 8B depicts the rear surface of a first substrate, showing the positions of the transducers.
Figures 9A-9C schematically depict a wave in a first substrate during a bonding process.

### DETAILED DESCRIPTION

Before describing embodiments of the invention in detail, it is instructive to present an example environment in which embodiments of the present invention may be implemented.

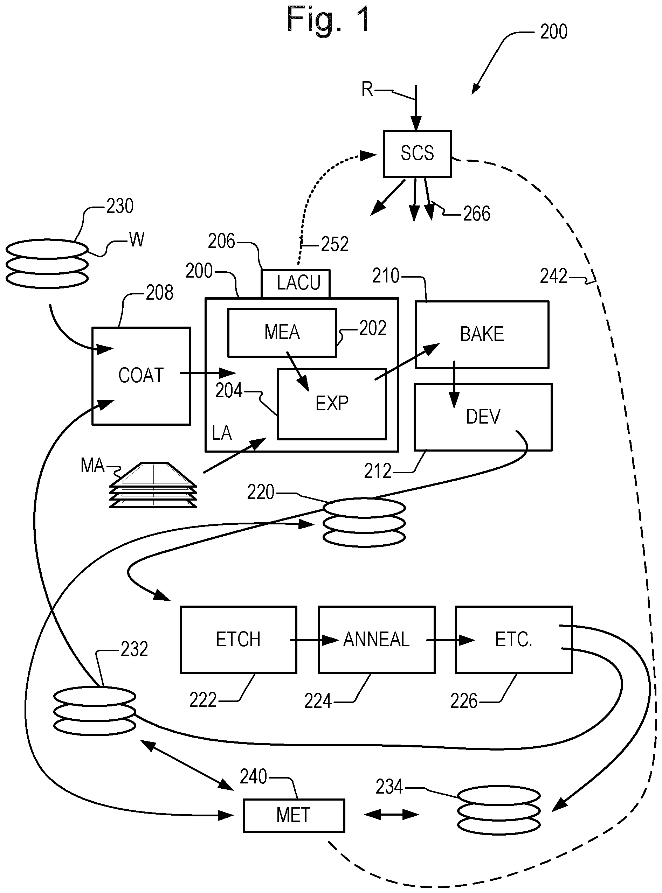

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on semiconductor substrates (e.g. semiconductor wafers). The products may form part of an electronic device. The skilled person will appreciate that a wide variety of products can be manufactured by processing different types of substrates in variants of this process. The production of semiconductor products is used purely as an example which has great commercial significance today.

Within the lithographic apparatus (or "litho tool" for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

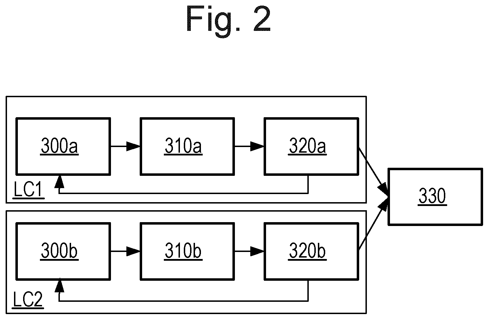

Figure 2 schematically depicts a device manufacturing arrangement/method for making bonded substrates (and therefore ICs based on bonded substrates) comprising a first manufacturing lithocell LC1 and a second manufacturing lithocell LC2. Within each lithocell is a lithographic processing system 300a, 300b and a first metrology system 310a, 310b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates (e.g. wafers) are completed from each of lithocell LC1 and lithocell LC2, they may be bonded within a bonding tool 330 to obtain a bonded wafer. A pair of substrates from a single lithocell (e.g. lithocell LC1) may also be bonded together. Bonding in this context may be wafer-to-wafer bonding where whole wafers are aligned and bonded together such that individual dies on each wafer are aligned. The concept of wafer-to-wafer bonding is known and used in many IC manufacturing processes. Bonding in this context may also be wafer-to-die or die-to-wafer bonding, in which an individual die is bonded to a wafer. Bonding in this context may also be die-to-die bonding, in which one individual die is bonded to another individual die. As used herein, the term "bonding method" is used to mean methods of bonding of one semiconductor substrate to another semiconductor substrate. The term "bonding method" is used to cover the bonding of one wafer to another wafer, of one die to a wafer, and of one die to another die. Further, as used herein (unless otherwise specified), the term "substrate" means "semiconductor substrate", which covers both wafers and dies.

The bonding tool 330 may comprise a bonding alignment device for aligning the substrates together for bonding. For example, the bonding tool 330 may perform pre-align using box-in-box marks provided to substrates (e.g., one box on each substrate), with visual inspection of marks used for alignment quality/ position control. Another method uses two imaging sensors (e.g., face to face) which are first calibrated together to find their relative positions; each sensor is then used to separately align a respective substrate to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly, metrology apparatuses 310 and 310b may be the same apparatus or different apparatuses. The software application 320a, 320b may be comprised within one or both of the respective lithographic processing systems 300a, 300b and/or one or both of the first metrology systems 310a, 310b, or elsewhere.

Once bonded, the bonded substrate may be subject to further lithographic patterning and processing. As such, alignment will be performed on the bonded substrate; e.g., for aligning the substrate and determining feed-forward corrections based on measured grid deformities. Also, post-exposure metrology, such as overlay metrology, may be performed on the bonded substrate after exposure; e.g., to determine feedback corrections for subsequent substrates.

At present, various bonding techniques have been implemented to bond semiconductor substrates (e.g. wafers). Among existing bonding techniques, fusion bonding and hybrid bonding are widely employed for bonding semiconductor substrates. Fusion bonding enables permanent connection via dielectric layers on each bonding semiconductor substrate and provides a good bonding strength with a high bonding yield. The dielectric layers may comprise, for example, silicon oxide, e.g. activated silicon oxide of the form SiOxHy. Additionally or alternatively, the dielectric layers may comprise, for example, SiON, e.g. activated SiON of the form SiOxNyHz. The activation of the silicon oxide or the SiON may comprise plasma activation or activation comprising use of a hydrogen radical generator or exposure to UV light.

Typically, the fusion bonding process comprises three main steps: 1) surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via Van der Waals forces between the two bonding surfaces and via hydrogen bridge bonds of chemisorbed water molecules. The hydrogen bridge bonds of chemisorbed water molecules may react during the annealing step to form covalent siloxane bonds. The spontaneous adhesion of the two bonding surfaces (e.g. through Van der Waals forces and the like) may be referred to as optical bonding. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

Hybrid bonding combines fusion bonding and metal diffusion bonding into a single bonding process and enables formation of dielectric-to-dielectric and metal-to-metal bonds between the bonding surfaces of the two substrates. The metal-to-metal bonds between the two substrates may provide one or both of: (a) increased bond strength between the two substrates; and (b) electrical connection between the two substrates (e.g. electrical connection between a functional device formed on one substrate and another functional device formed on another substrate).

In a hybrid bonding process, metal is embedded in bonding surfaces of the substrates that are to be bonded together. The metal may be copper, gold, or any other metal or metal alloy with a coefficient of thermal expansion that is greater than the coefficient of thermal expansion of the material from which the dielectric layer is formed. The metal may be embedded in the dielectric layer of the substrates that are to be bonded together. The metal embedded in the substrates may be in the form of a plurality of metallic portions (which may be referred to as metallic pads) distributed across the substrates (e.g. distributed across the dielectric layer of the substrates). The metallic portions may be formed in a surface preparation step of the hybrid bonding method. For example, the metallic pads may be formed by etching the dielectric layer on the substrate (e.g., to create vias to the metal below) and electroplating (or electrochemical deposition (ECD) of) at least part of the etched dielectric layer to form metal pads therewithin. The bonding surface of a substrate may also be referred to as a joining surface of the substrate.

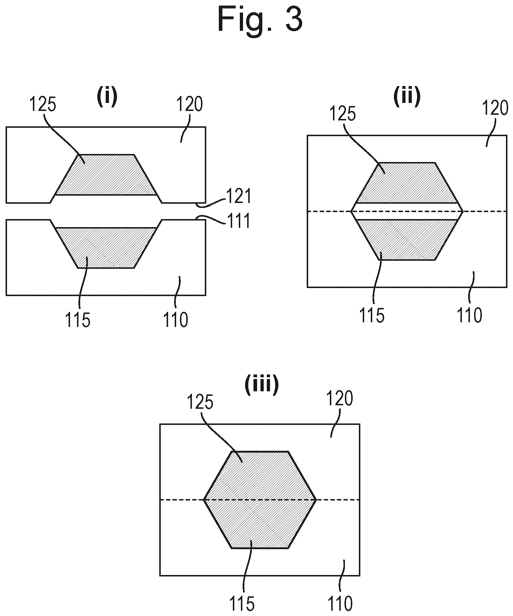

Similarly to the fusion bonding process, the hybrid bonding process also comprises the following three main steps: 1) surface preparation (in which the metallic portions may be formed, as described above); 2) pre-bonding at room temperature; and 3) annealing (or heat treatment) at elevated temperatures. Steps (2) and (3) are schematically depicted in Figure 3, which depicts a metallic portion 115 in a first substrate 110 and a metallic portion 125 in a second substrate 120. The single metallic portion on each of the first and second substrate 110, 120 is shown to explain the hybrid bonding process, and is representative of a plurality of metallic portions 115, 125.

At stage (i) in Figure 3, a bonding surface 111 of the first substrate 110 is separated (e.g. spaced apart from) from a bonding surface 121 of the second substrate 120. The bonding surface 111 of the first substrate 110 may be formed at least partially by a dielectric layer (not shown). The metallic portion 115 may be recessed below the bonding surface 121, but exposed at the bonding surface 121 (e.g. not covered by the dielectric layer). The bonding surface 121 of the second substrate 120 may be formed at least partially by a dielectric layer (not shown). The metallic portion 125 may be recessed below the bonding surface 121, but exposed at the bonding surface 121 (e.g. not covered by the dielectric layer).

In the hybrid bonding process, the two substrates 110, 120 may be aligned with one another. Then, the two substrates 110, 120 may be brought together such that the bonding surfaces 111, 121 come into contact, and are spontaneously bonded together (e.g. by optical bonding). At stage (ii) in Figure 3) the two substrates 110, 120 have been brought into contact with one another. At this point in the process, the metallic portion 115 of the first substrate 110 may not be bonded with (or in contact with) the metallic portion 125 of the second substrate 120. This may be because the metallic portions 115, 125 are recessed below the respective bonding surfaces 111, 121, as described above. By recessing the metallic portions 115, 125 below the respective bonding surfaces 111, 121, the metallic portions 115, 125 do not interfere with the initial optical bonding that occurs between the (dielectric) bonding surfaces 111, 121.

At stage (iii) in Figure 3, the two substrates 110, 120 have been subjected to an annealing (or heat treatment) step. As described above, the annealing (or heat treatment) transfers hydrogen bridge bonds to covalent siloxane bonds. Further, the heating of the metallic portions 115, 125 causes the metallic portions 115, 125 to expand up to or beyond the level of the respective bonding surfaces 111, 121. Thus, the metallic portions 115, 125 come into contact with one another. Where the metallic portions 115, 125 come into contact with one another, metal diffusion bonds may be formed. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In many fusion or hybrid bonding applications, intermediate layers (e.g., silicon dioxide (SiO2), silicon carbon nitride (SiCN), silicon oxynitride (SiON)) are used to enhance bonding strength.

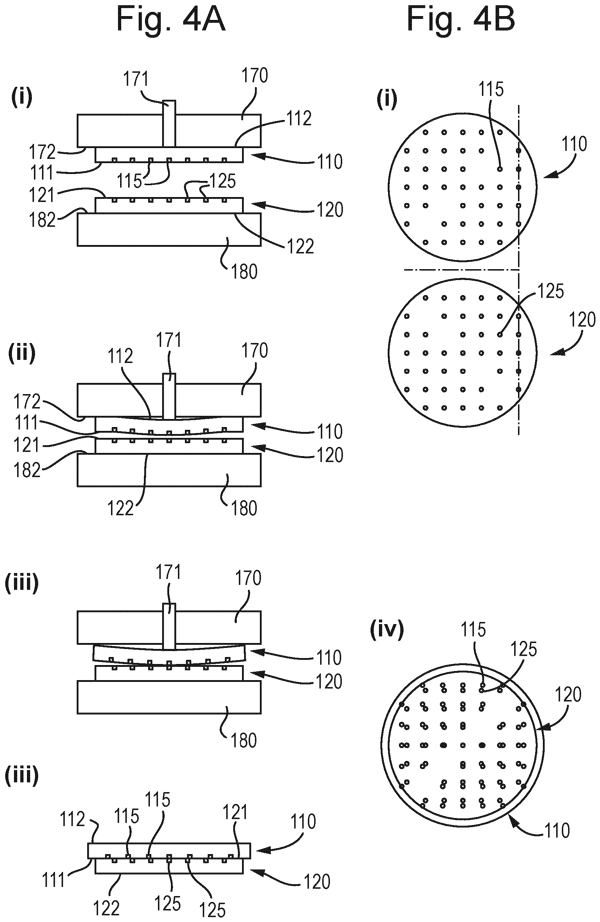

A conventional bonding method will now be described with reference to Figures 4A and 4B. The bonding method depicted in Figure 4A is a method for bonding a first semiconductor substrate 110 and a second semiconductor substrate 120. The first semiconductor substrate 110 comprises a bonding surface 111 and a plurality of metallic portions 115 distributed across the bonding surface 111. The second semiconductor substrate 120 also comprises a bonding surface 121 and a plurality of metallic portions 125 distributed across the bonding surface 121. This has been described in detail above.

In step (i) depicted in Figure 4A the first semiconductor substrate 110 is clamped to a first clamp 170. Specifically, a rear surface 112 of the first semiconductor substrate 110 is in contact with a clamping surface 172 of the first clamp 170. As used in the present disclosure, the "rear surface" 112 of a substrate is a surface which is opposite to the bonding surface 111. The rear surface 112 may also be referred to as an outer surface, where the bonding surface 111 is an inner surface.

The clamping surface 172 of the first clamp 170 may comprise a plurality of support protrusions ("burls", not shown in the Figures). The rear surface 112 of the first semiconductor substrate 110 may be supported on distal ends of the plurality of support protrusions. The first clamp 170 may be an electrostatic clamp comprising one or more electrodes (not shown) configured to apply an electrostatic clamping force to the first semiconductor substrate 110 to clamp the first semiconductor substrate 110 to the first clamp 170. Alternatively, the first clamp 170 may be a vacuum clamp. By contacting the rear surface 112 of the first semiconductor substrate, the support protrusions may prevent the first semiconductor substrate moving towards the first clamp 170 under the influence of the clamping force exerted by the first clamp 170.

The second semiconductor substrate 120 may be clamped to a second clamp 180 in substantially the same way as the first substrate 110 is clamped to the first clamp 170. The first clamp 170 and the second clamp 180 may be arranged such that the bonding surfaces 111, 121 of the first and second substrates 110, 120 face one another.

As shown in Figure 4B, during step (i) (i.e. before the first substrate 110 is brought into contact with the second substrate 120), the metallic portions 115 on the first substrate 110 may be substantially aligned with the metallic portions 125 portions on the second substrate 120.

The first clamp 170 may comprise a pushing means configured to push the first substrate 110 towards the second substrate 120. As shown in Figure 4A, the pushing means may comprise a pin 171. The pin 171 extends through a body of the first clamp 170. The pin 171 is extensible and retractable, so that the pin 171 can push the first substrate 110 towards the second substrate 120. The pin 171 may be configured to initiate contact between the first substrate 110 and the second substrate 120. Thus, the pin 171 may be configured to initiate spontaneous bonding between the first substrate 110 and the second substrate 120.

The pin 171 is located in a central (e.g. radially central) portion of the first clamp 170, such that the pin 171 pushes against a central (e.g. radially central) portion of the rear surface 112 of the first substrate 110. In the example depicted in Figure 4A, the second clamp 180 does not comprise a pushing means. However, the second clamp may comprise a pushing means, e.g. a pin like the pin 171 of the first clamp 170. The pushing means of the second clamp 180 may be instead of, or in addition to, the pushing means of the first clamp 170 (i.e. the pin 171). Thus, in some embodiments, bonding between the first substrate 110 and the second substrate 120 may be initiated by pushing the first substrate 110 towards the second substrate 120 and pushing the second substrate 110 towards the first substrate simultaneously.

In steps (ii) and (iii), the first substrate 110 is brought into contact with the second substrate 120. To bring the first substrate into contact which the second substrate 120, the clamping force (e.g. electrostatic clamping force or vacuum clamping force) exerted on the first substrate 110 by the first clamp 170 (e.g. by one or more electrodes in the first clamp 170 or by a pressure difference) is released or reduced. Simultaneously, the pin 171 is extended so as to apply a pushing force to the rear surface 112 of the first substrate 110.

As the pin 171 pushes against the central portion of the first substrate 110, the central portion of the first substrate 110 moves towards the second substrate 120. Thus, a central portion of the bonding surface 111 of the first substrate 110 comes into contact with the bonding surface 121 of the second substrate. As the central portion of the bonding surface 111 of the first substrate 110 comes into contact with the bonding surface 121 of the second substrate 120, spontaneous bonding (e.g. by Van der Waals forces and the like) occurs therebetween. This spontaneous bonding causes the first substrate 110 to be pulled down onto the second substrate 120. This occurs first at the radially-central portion of the first substrate 110, and then propagates radially outwards. The radially outward propagation of the region at which the bonding surface 111 of the first substrate 110 is bonded to the bonding surface 121 of the second substrate 120 is referred to as a bond front (or "bond wave"). The bond wave propagates from the point of bond initiation (which corresponds to the position of the pin 171) to the edges of the first semiconductor substrate 110. As the first substrate 110 is pulled down onto the second substrate 120, air (or other gas) between the two substrates 110, 120 is displaced.

The speed at which the bond front propagates over the first substrate 110 may depend on various factors, such as: surrounding atmosphere pressure, temperature, the surrounding gas type, the surrounding gas density.

Even if the bond front is substantially uniform, the propagation of the bond front from the central initiation point to the edges of the substrate may lead to an expansion (e.g. a stretch) of the first substrate 110 in the radial direction. Consequently, at step (iv) in Figure 4A -where the first substrate 110 and the second substrate 120 have been bonded together and removed from the first and second clamp 170, 180-the metallic portions 115 of the first substrate may not be aligned with the metallic portions of 125 of the second substrate 120. Specifically, the metallic portions 115 of the first substrate 110 may be displaced radially outwards compared to the metallic portions 125 of the second substrate 120.

Once the first substrate 110 is fully in contact with second substrate 120 (and therefore the first substrate 110 is bonded to the second substrate 120), the first substrate 110 may not be able to contract (i.e. relax) back to its original dimensions. Thus, the first substrate 110 may remain in its radially-expanded form. Thus, the metallic portions of the first substrate 110 may remain misaligned relative to the metallic portions of the second substrate 120. Misalignment of the metallic portions may mean that the product does not function as intended. This may mean that yield is reduced, because a significant number of products are defective. It is noted that the metallic portions may be very small relative to the substrate W, and any (e.g. even partial) misalignment between the metallic portions may lead to a worsening of the performance of the product.

The speed at which the bond front propagates over the first substrate 110 may also depend on: patterns (e.g. structures) in the first substrate 110; crystal orientations in the first substrate 110; and pre-existing tensions in the first substrate 110. These factors may not be uniform over the surface of the first substrate 110. Consequently, the propagation of the bond front may not occur uniformly (i.e. the propagation of the bond front may be non-isotropic). Pre-existing curvature in the first substrate 110 and/or the second substrate 120 may also lead to non-uniformity in the propagation of the bond front. A non-uniform propagation of the bond front may lead to local tensions in the first substrate 110, which in turn lead to distortions in the first substrate 110.

The speed at which the bond front propagates radially outward may vary as a function of position (e.g. relative to the first substrate 110 and/or the second substrate 110). The speed at which the bond front propagates radially outward may vary as a function of position in the radial direction, e.g. the bond front may speed up and/or slow down as it propagates radially outward. Additionally or alternatively, the speed at which the bond front propagates radially outward may vary as a function of position in the azimuthal (or circumferential) direction, e.g. the speed of propagation of the bond front may depend on the direction in which the bond front is travelling. Thus, at any given time, a portion of the bond front at a first azimuthal position may be propagating at a speed which is different to the speed of another position of the bond front at a second, different azimuthal position.

The patterns (e.g. structures) in the first substrate 110 which affect the speed at which the bond front propagates may include, for example, scribe lanes, which are extended lines that cross large sections of the first substrate 110. Scribe lanes are regions extending across the substrate that are free of functional components (though may include markers used during manufacture) where the substrate will be separated into separate devices, e.g. by dicing. Structures such as scribe lanes may be arranged in a rectangular pattern, and thus may lead to a rectangular pattern in the propagation of the bond front.

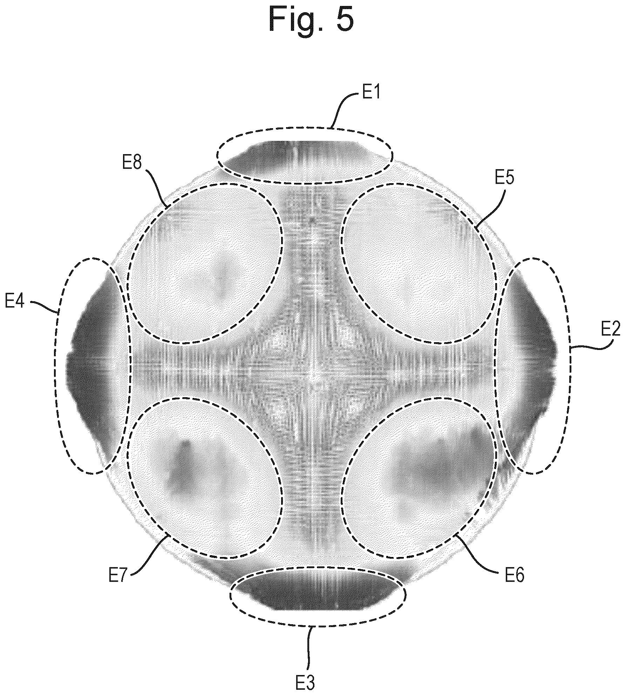

A bond front which propagates with a rectangular pattern may lead to distortions in the first substrate 110 having a rectangular pattern. Figure 5 depicts a plot of the overlay error across a first substrate 110 that has been bonded to a second substrate 120. There are two groups of areas of high overlay error. Each group comprises four areas situated at 90-degree intervals (in the azimuthal direction) around the first substrate 110. In other words, the distribution of overlay error may have four-fold symmetry about the center of the first substrate 110. A first group comprises areas E1, E2, E3 and E4. A second group comprising areas E5, E6, E7 and E8.

Distortions formed in the first substrate 110 may have a negative effect on the product that comprises the bonded semiconductor substrates. For example, distortions may mean that the product does not function as intended. It may not be possible to correct the distortions in subsequent steps of the manufacturing process. Consequently, the occurrence of distortion in the first substrate 110 during the bonding method may mean that yield is reduced, because a significant number of products are scrapped.

The present disclosure provides methods of bonding the first substrate 110 and the second substrate 120 which result in less distortion of the substrates (e.g. the first substrate 110 and/or the second substrate 120) as they are bonded together. Consequently, various advantages are realized, such as improved functionality and reliability of the products that are formed from the bonded substrates 110, 120, increased yield (because fewer products are scrapped after being determined to be malfunctioning), etc.

In particular, the present disclosure relates to bonding methods (and apparatuses for performing bonding methods) in which the speed of propagation of the bond front is modified using waves and/or vibrations induced in the first substrate 110 and/or the second substrate 120, and/or in a medium between the first substrate 110 and the second substrate 120. The waves may be in waves in the substrates 110, 120 that are being bonded together (i.e. the first substrate 110 and/or the second substrate 120), and/or waves in a medium around the substrates that are being bonded together (i.e. a medium around the first substrate 110 and/or the second substrate 120).

The waves and/or vibrations in the first substrate 110 and/or the second substrate 120 may interact with the bond front to modify the propagation of the bond front, as is described in more detail below. The modification of the speed of the propagation of the bond front may be to increase bond front uniformity in the azimuthal direction. Bonding methods in accordance with the present disclosure may be similar to the bonding method described in relation to Figures 4A and 4B, except as described below.

In accordance with a first embodiment of the present disclosure, there is method in which the propagation of the bond front is modified by inducing a mechanical deformation profile in the first substrate 110. The mechanical deformation profile may comprise oscillatory deformation of the first substrate 110 in a direction which is substantially perpendicular to the plane in which the first substrate 110 extends. The mechanical deformation profile may also be referred to as a vibration profile. The mechanical deformation profile may be induced by driving at least one vibrational mode of the first substrate 110.

The vibrational modes (also referred to as eigenmodes) of an object (e.g. a substrate) are the shapes/patterns of vibration (e.g. deformation) undergone by the object when the object is excited (e.g. subjected to a disturbance). In theory, objects have infinite vibrational modes.

Each vibrational mode of an object has a corresponding eigenfrequency. When an object is excited at an eigenfrequency of the object, resonance occurs, and the object will vibrate in the vibrational mode corresponding to the eigenfrequency.

The vibration exhibited by an object may be the summation of a plurality of vibrational modes of the object. Exciting an object at a plurality of different eigenfrequencies causes the object to vibrate in a plurality of vibrational modes. The overall vibration (i.e. the total mechanical deformation profile) which is exhibited by the object may be the sum of the vibrations in the plurality of vibrational modes.

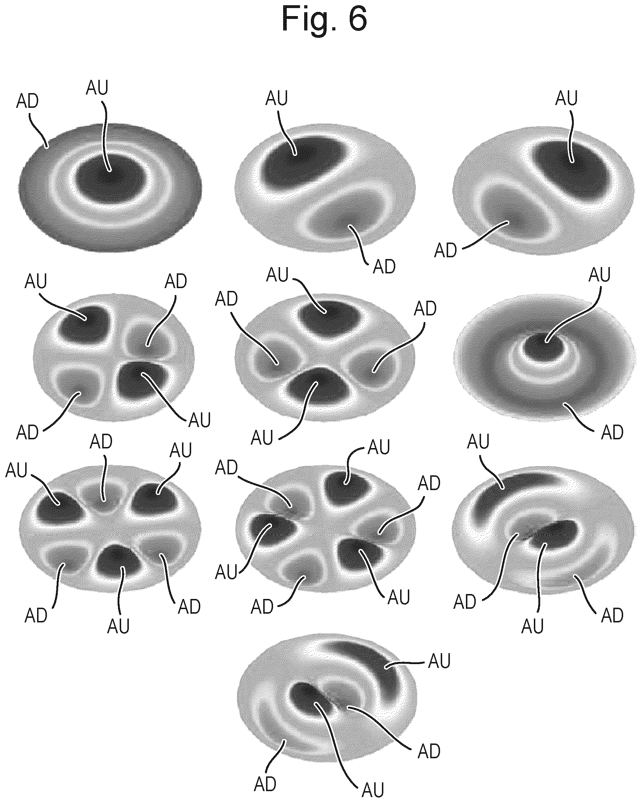

Figure 6 depicts several vibrational modes of a circular membrane. The vibrational modes of the circular membrane are indicative of the types of vibrational modes that may be induced in the first substrate 110. The vibrational modes comprise deformation of the circular membrane perpendicular to the plane in which the circular membrane extends. The vibrational modes depicted in Figure 6 are labelled in the nomenclature *(d, c),* where *d* is the number of nodal diameters and c is the number of nodal circles. Each vibrational mode depicted in Figure 6 has a corresponding eigenfrequency. All of the vibrational modes are symmetrical about the centre of the circular membrane.

Each vibrational mode comprises at least one node and at least one antinode. A node is a point or line that is not displaced (i.e. does not move) while the rest of the structure is oscillating (vibrating). An antinode is a point or line of maximum displacement. In Figure 6, antinodes in each of the vibrational modes are labelled AU or AD. The label AU indicates an antinode at the uppermost point in its oscillatory cycle (which may be referred to as a maximum), and the label AD indicates an antinode at its lowermost point in its oscillatory cycle (which may be referred to as a minimum).

To drive a vibrational mode of the circular membrane, the circular membrane may be excited at or near an eigenfrequency corresponding to the vibrational mode. For example, an oscillatory contact force (with a frequency equal to the eigenfrequency of the vibrational mode) may be applied to the circular membrane. The oscillatory contact force may be applied anywhere on the circular membrane, apart from at a node of the vibrational mode. The efficiency with which a mode can be excited is proportional to the amplitude of the mode at the driving position. Thus, when driving a vibrational mode, it is more efficient to apply the oscillatory contact force at or near an antinode of the vibrational mode.

More complex vibrational profiles may be induced in the circular membrane by exciting the circular membrane at a plurality of vibrational modes. The circular membrane may be excited at the plurality of vibrational modes by applying a plurality of oscillatory contact forces to the circular membrane. For example, a first oscillatory contact force may be applied at or near a first eigenfrequency corresponding to a first vibrational mode of the circular membrane, and a second oscillatory contact force may be applied at or near a second eigenfrequency corresponding to a second vibrational mode of the circular membrane. The total vibration response exhibited by the circular membrane may be the sum of the vibration in the first vibrational mode and the vibration in the second vibrational mode.

In the context of the present application, the driving of at least one vibrational mode of the first substrate 110 may mean causing the first substrate 110 to resonate in at least one vibrational mode. This may be achieved by exciting the first substrate 110 to cause resonance of the at least one vibrational mode. For example, the driving of the at least one vibrational mode may comprise excitation of the first substrate 110 at the eigenfrequency associated with the at least one vibrational mode.

As will be appreciated, the excitation of the first substrate 110 need not be exactly at the eigenfrequency associated with the at least one vibrational mode for the first substrate 110 to resonate in the at least one vibrational mode. The excitation of the first substrate 110 may be near the eigenfrequency associated with the at least one vibrational mode, e.g. within 10% of the eigenfrequency associated with the at least one vibrational mode.

The driving of the at least one vibrational mode of the first substrate 110 may comprise applying at least one oscillatory contact force to first substrate 110. For example, the driving of the at least one vibrational mode of the first substrate 110 may comprise applying at least one oscillatory contact force to the rear surface 112 of the first substrate 110. Further description relating to how the at least one vibrational mode of the first substrate 110 may be driven is provided below.

The first substrate 110 may have similar vibrational modes to the vibrational modes of the circular membrane. However, the first substrate 110 may differ from the circular membrane in several important ways. For example, the first substrate 110 may not have a spatially-uniform density or stiffness because of patterns (e.g. structures) formed thereon. The structures may include circuit patterns, gratings and scribe lanes. The first substrate 110 may also have non-uniform crystal orientations and pre-existing tensions. The structures formed on the first substrate 110 (and the non-uniform crystal orientations and pre-existing tensions) may break the point symmetry of the vibrational modes which is exhibited for the circular membrane.

The structures formed on the first substrate 110 may be arranged along two perpendicular axes (e.g. along an X-axis and a Y-axis). Consequently, some of the vibrational modes that may be induced in the first substrate 110 may have four-fold symmetry. In some embodiments, inducing a mechanical deformation profile in the first substrate 110 that has four-fold symmetry may be particularly effective at reducing overlay error during bonding. This is because of the four-fold symmetry in the distribution of overlay error, which was described with reference to Figure 5.

The speed of the propagation of a bond front may be increased in regions where the the first substrate 110 is vibrating, as explained below.

In general, the radially-outward propagation of the bond front is caused by intermolecular forces (e.g. Van der Waals forces), which pull the bonding surface 111 of the first substrate down onto the bonding surface 121 of the second substrate 120. The intermolecular forces between the bonding surfaces 111, 121 of the first and second substrates 110, 120 can only act over a very short range. Thus, for a given portion of the bonding surface 111 of the first substrate 110 to be pulled down onto the bonding surface 121 of the second substrate 120, a distance between the given portion of the bonding surface 111 of the first substrate and the bonding surface 121 of the second substrate 120 must be decreased to less than the range of the intermolecular forces.

The given portion is brought into the range of the intermolecular forces by a portion radially inward of the given portion being pulled down onto the bonding surface 121 of the second substrate 120. Once the given portion is within the range of the intermolecular forces, the given portion is pulled down onto the bonding surface 121 of the second substrate 120, which brings a portion radially outward of the given portion into the range of the intermolecular forces. In this way, the bond front propagates radially outwards.

If the first substrate 110 is vibrating, the oscillatory deformation of the first substrate 110 is deformation in the direction in which the first substrate 110 is separated from the second substrate 120. Thus, at a maximum in the oscillatory cycle, the oscillatory deformation of the first substrate 110 increases the distance between the bonding surfaces 111, 121 of the first and second substrates 110, 120. In the same way (and more importantly), at a minimum in the oscillatory cycle, the oscillatory deformation of the first substrate 110 decreases the distance between the bonding surfaces 111, 121 of the first and second substrates 110, 120.

Consequently, if the given portion of the bonding surface 111 of the first substrate 110 is in an oscillating region of the first substrate 110 (e.g. at or near an antinode of a vibration mode that is being driven), the oscillation of the first substrate 110 may decrease the distance between the bonding surfaces 111, 121 of the first and second substrates 110, 120 to be less than the range of the intermolecular forces. This occurs at or around the minimum in the oscillatory cycle. Thus, the oscillatory deformation of the first substrate 110 can cause the given portion of the bonding surface 111 of the first substrate 110 to be pulled down onto the bonding surface 121 of the second substrate 120 sooner than would have been the case in the absence of oscillations. Consequently, the speed of propagation of the bond front is increased in the oscillating region.

In view of the above, in the first embodiment, the mechanical deformation profile induced in the first substrate 110 may have oscillating regions where the speed of bond front propagation is naturally slow (e.g. slow relative to the speed of bond front propagation at other parts of the first substrate 110). By doing this, the speed of bond front propagation is increased in regions where the speed of bond front propagation is naturally slow, and the uniformity (e.g. azimuthal uniformity) with which the bond front propagates radially outward can be improved. The mechanical deformation profile induced in the first substrate 110 may have non-oscillating regions (or regions where an amplitude of oscillations is small) where the speed of bond front propagation is naturally fast (e.g. fast relative to the speed of bond front propagation at other parts of the first substrate 110).

The mechanical deformation profile may be induced by driving at least one vibrational mode of the first substrate 110. For example, the mechanical deformation profile may be induced by driving a single vibrational mode of the first substrate 110. Alternatively, the mechanical deformation profile may be induced by driving a plurality of vibrational modes of the first substrate 110, where the mechanical deformation profile is a summation of the vibrations in each of the plurality of vibrational modes.

To determine a desired mechanical deformation profile for the first substrate 110 (i.e. a mechanical deformation profile which modifies the speed of bond front propagation in a desired way, e.g. to improve bond front propagation uniformity), one or more of the following steps may be performed.

The speed at which the bond front propagates (e.g. naturally propagates, e.g. propagates in the absence of vibration) as a function of position relative to the first substrate 110 may be obtained. The speed at which the bond front propagates referred to in the previous sentence may be the speed at which the bond front propagates during the bonding of the first substrate 110 and the second substrate 120 as depicted in Figure 4A.

Based on the speed at which a bond front propagates as a function of position relative to the first substrate 110, a desired mechanical deformation profile may be determined. The desired mechanical deformation profile may be a profile of vibration over the first substrate 110. The desired mechanical deformation profile may comprise regions of large deformation where the bond front propagates relatively slowly, and regions of smaller deformation (or substantially no deformation) where the bond front propagates relatively quickly.

Instead of directly obtaining the speed at which a bond front propagates as a function of position relative to the first substrate 110, an indication of the speed at which a bond front propagates as a function of position relative to the first substrate 110 may be obtained. The indication may be, for example, a spatial distribution of a quality metric (e.g. overlay error) for a first substrate 110 that has been subjected to the bonding process (e.g. which has been bonded to a second substrate 120). The determination of the desired mechanical deformation profile may be based on the obtained indication of the speed at which a bond front propagates as a function of position relative to the first substrate 110.

Once the desired mechanical deformation profile has been determined, at least one vibrational mode of the first substrate 110 may be selected. The selected at least one vibrational mode of the first substrate 110 may be a vibrational mode which causes, or contributes to, the desired mechanical deformation profile.

With, or after, the selection of the at least one vibrational mode, the eigenfrequency of the at least one vibrational mode may be determined. That is, a frequency which drives the selected at least one vibrational mode in the first substrate 110 may be determined.

With, or after, the selection of the at least one vibrational mode, other parameters associated with the selected at least one vibrational mode may be determined. For example, optimum positions for exciting the first substrate 110 at the selected at least one vibrational mode may be determined. The optimum positions may be at or near antinodes of the selected at least one vibrational mode. Additionally or alternatively, an amplitude with which the first substrate 110 should be excited at the selected at least one vibrational mode may be determined.

In the simplest case, the desired mechanical deformation profile may be (or correspond to) one (i.e. a single) vibrational mode of the first substrate 110. In this case, the one vibrational mode of the substrate 110 may be selected. The selected one vibrational mode may comprise antinodes in regions of the first substrate 110 in which the speed of the bond front is relatively low, and nodes in regions of the first substrate 110 in which the speed of the bond front is relatively high.

In other cases, the desired mechanical deformation profile may be more complex, and to form the desired mechanical deformation profile, a plurality of vibrational modes may be required. Thus, a plurality of vibrational modes may be selected. The desired mechanical deformation profile may be achieved by the sum of vibrations in each of the selected vibrational modes.

For example, a first vibrational mode (with a first eigenfrequency) and a second vibrational mode (with a second eigenfrequency) may be selected. The desired mechanical deformation profile may be achieved by the sum of vibrations in the first vibrational mode and vibrations in the second vibrational mode.

Where a plurality of vibrational modes are selected, an operating frequency, optimum position, and/or amplitude may be determined for each of the plurality of vibrational modes.

The operating frequency for each vibrational mode of the plurality of vibrational modes may be the frequency which drives the vibrational mode (i.e. the eigenfrequency of the vibrational mode).

The optimum position and amplitude of excitation for each of the plurality of oscillation modes may be selected such that the desired mechanical deformation profile is obtained by the combination of the plurality of vibrational modes. For example, it may be the case that one of the vibrational modes of the plurality of vibrational modes must be dominant in order for the desired mechanical deformation profile to be achieved. To increase the dominance of the one vibrational mode, an amplitude associated with the excitation of the first substrate 110 at the one vibrational mode may be higher than amplitudes associated with the other vibrational modes.

To enable the selection of the at least one vibrational mode, a plurality of vibrational modes of the first substrate (and their corresponding eigenfrequencies) may be obtained or determined. For example, a plurality of vibrational modes of the first substrate (and their corresponding eigenfrequencies) may be obtained by analysis involving modelling the first substrate 110 using a finite element method. Additionally or alternatively, a plurality of vibrational modes of the first substrate (and their corresponding eigenfrequencies) may be obtained empirically, e.g. by practical experimentation on one or more test substrates. The test substrate may be similar to, or the same as, the first substrate 110 (at least insofar as the properties that affect the vibrational modes of the substrate, e.g. the structures formed on the substrate, the crystal structures in the substrate, etc.). The practical experimentation may comprise measuring a vibrational response of the test substrate when subjected to a disturbance. The measuring of the vibrational response may be performed using an interferometer.

Another empirical approach to selection of one or more vibrational modes is to experiment with the application of different frequencies during actual bonding processes and monitoring yield.

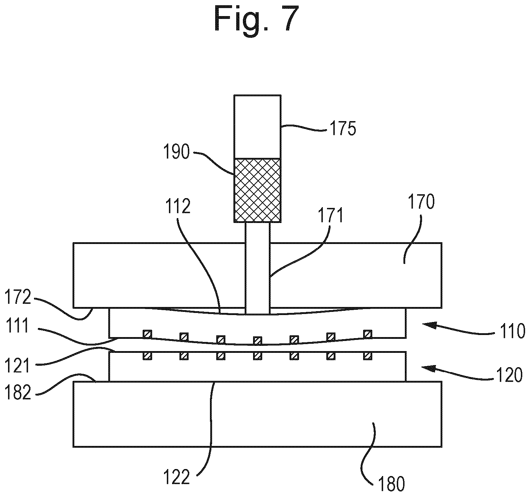

Figure 7 depicts a bonding apparatus which may be used to perform the methods of the present disclosure. The bonding apparatus is similar to the bonding apparatus depicted in Figure 4A, and comprises a pin configured to push against the central portion rear surface 112 of the first substrate 110 to initiate bonding between the first substrate 110 and the second substrate 120. In the bonding apparatus depicted in Figure 7, the oscillatory contact force is applied to the first substrate 110 via the pin 171.

The bonding apparatus comprises a transducer 190, which is coupled to the pin 171. The transducer may be a component configured to convert electricity into oscillatory motion. Thus, the transducer may be configured to apply an oscillatory contact force to the rear surface 112 of the first substrate 110 via the pin 171.

The bonding apparatus may further comprise an actuator 175. The actuator 175 may be coupled to the pin 171. The actuator 175 may configured to actuate the pin 171 so as to extend and retract the pin 171. The actuator 175 may be provided in addition to the transducer 190. The actuator 175 may be configured to move the pin 171 over a greater distance than the transducer 190. The transducer 190 may be configured to move the pin 171 at a higher speed/frequency than the actuator 175.

In some embodiments, the functionality of the actuator 190 and transducer 175 may be incorporated into a single component.

As explained above, the vibrational modes of the first substrate 110 may not have point symmetry. Thus, it may be possible to drive substantially all of the vibrational modes of the first substrate 110 using the centrally-located pin 171 (even though, for the idealized circular membrane, several of the vibrational modes comprise a node at the radial center).

It is not essential that the driving of the at least one vibrational mode of the first substrate 110 comprises the application of an oscillatory contact force to the first substrate using the pin 171. For example, the oscillatory contact force may be applied to the first substrate 110 (e.g. to the rear surface 112 of the first substrate 110) by a transducer that is not associated with the pin 171. Such a transducer may be integrated within the first clamp 170. The transducer may be centrally-located, but distinct from the pin 171. For example, the transducer may extend circumferentially around the pin 171.

It is not essential that the driving of the at least one vibrational mode of the first substrate 110 comprises the application of an oscillatory contact force. For example, the driving of the at least one vibrational mode of the first substrate 110 may comprise acoustically driving the at least on vibrational mode of the first substrate 110, e.g. using an acoustic transducer.

The acoustic transducer may be configured to induce a mechanical vibration in the first substrate acoustically. In particular, the acoustic transducer may induce a vibration (i.e. an acoustic wave) in the medium surrounding the first substrate 110. The vibration (i.e. the acoustic wave) in the medium surrounding the first substrate 110 may induce the mechanical vibration of the first substrate 110. The acoustic transducer may induce the vibration (i.e. the acoustic wave) in the medium between the bonding surfaces 111, 121 of the first and second substrates 110, 120, or may induce the vibration (i.e. the acoustic wave) elsewhere around the first substrate 110.

The frequencies of interest in the first embodiment (i.e. the eigenfrequencies corresponding to the vibrational modes to be induced in the first substrate 110) may be in the order of tens of kilohertz. Thus, standard mechanical and acoustic transducers may be used. In some embodiments, the mechanical or acoustic transducer may comprise one or more piezoelectric elements.

Where a plurality of vibrational modes of the first substrate 110 are to be driven, a plurality of oscillatory contact forces may be applied to the first substrate 110, e.g. by a plurality of transducers at a plurality of different positions. Alternatively, a plurality of vibrational modes of the first substrate 110 may be driven by a single contact force, e.g. a single contact force applied by a single transducer at a single position. The single transducer may apply a contact force which varies in accordance with a function that is based on a plurality of eigenfrequencies. In other words, the single contact force may not be a pure, single-frequency tone, but may instead be composed of a plurality of superimposed frequencies.

Where a plurality of oscillatory contact forces are applied to the first substrate 110, they may each be applied to the rear surface 112 of the first substrate 110. The plurality of oscillatory contact forces may be applied at different positions on the rear surface 112 of the first substrate 110. The plurality of oscillatory contact forces may be applied at a plurality of frequencies, such that the plurality of vibrational modes can be driven. The plurality of oscillatory contact forces may be applied at different amplitudes, such that the combination of the vibrations in each of the plurality of vibrational modes results in the desired mechanical deformation profile.

Each oscillatory contact force may be applied by a different mechanical transducer. Each mechanical transducer may be configured to apply a contact force to a specific position on the rear surface 112 of the first substrate 110. Thus, each oscillatory contact force may be applied at a different position on the rear surface 112 of the first substrate 110.

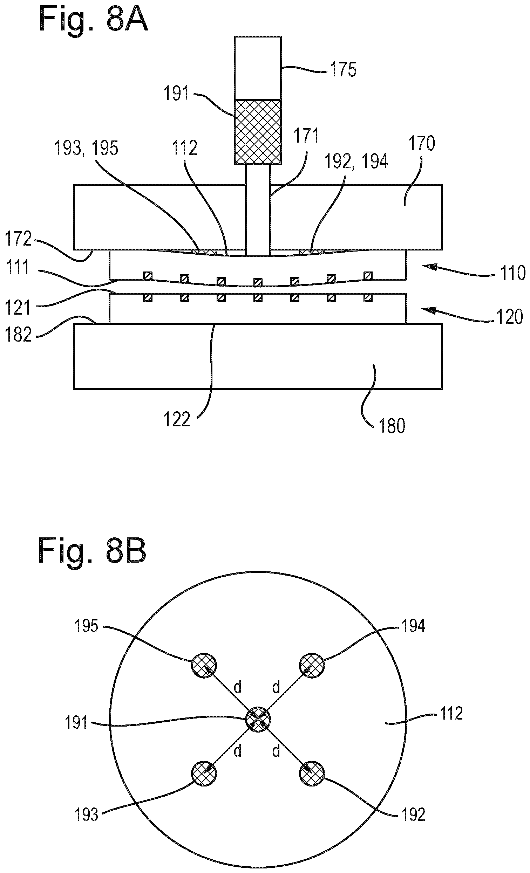

Figures 8A and 8B depict a bonding apparatus comprising a plurality of mechanical transducers. The bonding apparatus comprises a first transducer 191, which is coupled to the pin 171 as described in relation to Figure 7. The bonding apparatus further comprises four additional transducers: a second transducer 192, a third transducer 193, a fourth transducer 194, and a fifth transducer 195. The second to fifth transducers 192-195 may be radially outward of the pin 171. In some embodiments, the bonding apparatus may not comprise a transducer coupled to the pin 171, and the bonding apparatus may only comprise radially-outward transducers (e.g. the second to fifth transducers 192-195 in the example depicted in Figures 8A and 8B).

The second to fifth transducers 192-195 may not be associated with a pin and actuator in the same way as the first transducer 191. The second to fifth transducers 192-195 may be configured to apply an oscillatory contact force to the rear surface 112 of the first substrate 110 without leading to a bond initiation point between the first substrate 110 and the second substrate 120. For example, an amplitude of the oscillations applied to the first substrate by the second to fifth transducers 192-195 may be insufficient to bring the bonding surfaces 111, 121 of the first and second substrates 110, 120 into contact with one another.

The second to fifth transducers 192-195 may be configured so as to remain in contact with the rear surface 112 of the first substrate 110 as the first substrate 110 moves away from the first clamp 170 during the bonding process. This may be achieved, for example, by providing an extendable element which extends as the first substrate 110 moves away from the first clamp 170.

To improve the ability with which the second to fifth transducers 192-195 are able to induce vibrations in the first substrate 110, the second to fifth transducers 192-195 may be pressed against the rear surface 112 of the first substrate 110. To improve the ability with which the second to fifth transducers 192-195 are able to induce vibrations in the first substrate 110, the second to fifth transducers 192-195 may be clamped to the rear surface 112 of the first substrate, e.g. by electrostatic clamping.

The second to fifth transducers 192-195 may be symmetrically arranged about the radial centre of the rear surface of the first substrate. Thus, an arrangement of the positions at which the plurality of oscillatory contact forces are applied may be symmetrical about the radial centre of the rear surface of the first substrate.

A distance d between each of the second to fifth transducers 192-195 and the radial centre of the rear surface 112 of the substrate 110 may be the same. Thus a distance between a position at which an oscillatory contact force is applied and the radial centre of the rear surface of the first substrate may be the same for each of at least a portion of the plurality of oscillatory contact forces.

The second to fifth transducers 192-195 may be positioned at the vertices of a square. Thus, the positions at which the at least a portion of the plurality of oscillatory contact forces are applied may be the vertices of a square. The square may be centred at the radial centre of the first substrate 110 (which may be coincident with the pin 171).

While five transducers are depicted in Figures 8A and 8B, any number of transducers may be used.

With the exception of the transducer that is coupled to the pin 171, the transducers may be positioned at the vertices of a regular polygon, wherein a centre of the polygon is the radial centre of the rear surface of the first substrate 110. The polygon may be, for example, a square, a hexagon, or an octagon.

While the above-described regular and symmetrical arrangement of transducers may be advantageous in some implementations, it is not essential. For example, as an adaptation of the embodiment depicted in Figures 8A and 8B, the second to fifth transducers 192-195 may be arranged in a rectangle rather than a square. Additionally, where more transducers are provided, they may not each form a vertex of a regular polygon. For example, where a large number of transducers are provided, they may be arranged in concentric rings (where each concentric ring may be a regular or non-regular polygon).

A large advantage of providing a plurality of transducers is that the first substrate 110 can be excited at a plurality of frequencies, and thus a plurality of vibrational modes of the first substrate 110 can be driven. However, a plurality of transducers my also be advantageous when driving a single vibrational mode of the first substrate 110. Thus, the plurality of transducers may apply the plurality of oscillatory contact forces with the same frequency. Additionally or alternatively, the plurality of transducers may apply the plurality of oscillatory contact forces with the same amplitude. Additionally or alternatively, the plurality of transducers may apply the plurality of oscillatory contact forces in-phase.

An advantage of providing a plurality of transducers (whether driving one or a plurality of vibrational modes) is that a likelihood that at least one transducer is located at or near an antinode of the vibrational mode(s) is increased. Thus, it is more likely that the desired mechanical deformation profile will be achieved efficiently, because it is more efficient to drive vibrational modes at or near the antinodes. In particular, by providing transducers that are radially outward of the radial centre of the first substrate 110, it is possible to drive vibrational modes in the first substrate 110 even if they are point-symmetric like the circular membrane vibrational modes depicted in Figure 6.

Another advantage is as follows. In the case that only a single transducer 190 is provided, and that transducer is coupled to the pin 171, the ability of the transducer to drive vibrational modes in the first substrate is hindered once the central region of the bonding surface 111 of the first substrate 110 has come into contact with the bonding surface 121 of the second substrate 120 (i.e. after the point in time depicted in Figure 4A(iii)). This is because, after the central region of the bonding surface 111 of the first substrate 110 has come into contact with the bonding surface 121 of the second substrate 120, the central portion of the first substrate 110 is bonded to the second substrate 120, and thus is unable to move up and down. By providing a plurality of transducers, some of which are radially outward of the centre of the first substrate 110 (e.g. as shown in Figure 8), it is possible to effectively drive the vibrational modes of the first substrate for a larger portion of the bonding process.

It should be noted that, after the central region of the bonding surface 111 of the first substrate 110 has come into contact with the bonding surface 121 of the second substrate 120, it may still be possible to drive vibrational modes in the first substrate 110 using a transducer 190 coupled to the pin 171. For example, it may be possible to drive vibrational modes in the first substrate 110 by driving vibration of the combination of the first and second substrates 110, 120 using the transducer 190 coupled to the pin 171. Additionally or alternatively, it may be possible to drive vibrational modes in the first substrate 110 by inducing waves within the first substrate 110 (e.g. waves comprising compression and expansion of the first substrate 110) using the transducer 190 coupled to the pin 171.

In accordance with a second embodiment of the present disclosure, there is method in which the propagation of the bond front is modified by generating a wave in the first substrate 110 or a medium around the first substrate 110. The wave may be referred to as a pressure wave. The wave may be configured to interact with a bond front to modify a speed of propagation of the bond front.

The wave may be a wave in the first substrate 110 itself. The wave may comprise deformation and/or deflection and/or compression and expansion of the first substrate 110. The deflection may be dominant. The wave may comprise a transverse component (e.g. a component comprising displacement of portions of the first substrate 110 in a direction perpendicular to the plane in which the first substrate 110 extends). Additionally or alternatively, the wave may comprise a longitudinal component, e.g. a component comprising compression and expansion (rarefaction) of the first substrate 110. Waves comprising a significant transverse component may be particularly beneficial for the present method.

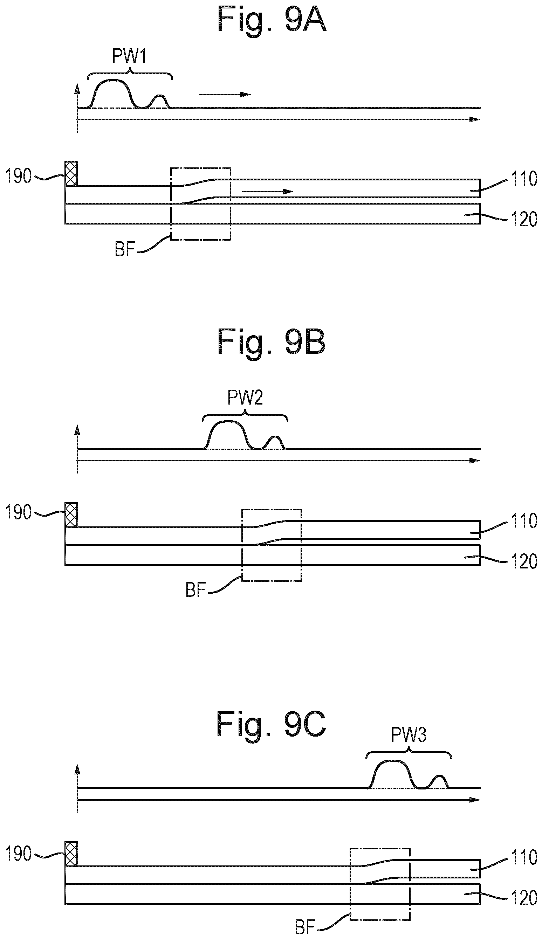

The wave may be generated by a transducer. Figure 9A-9C depict an example of waves PW1, PW2, PW3 which are generated in the first substrate 110 by the transducer 190.

Each of Figures 9A-9C depict a representation of the first and second substrates 110, 120, and above that, a plot of disturbance in the first substrate 110 against position. The plots are aligned with the representations of the first and second substrates 110, 120. The disturbance shown in the plot may be, for example, displacement of the first substrate 110 (or a portion thereof) in the direction perpendicular to the plane in which the first substrate 110. This displacement may comprise deformation and/or deflection and/or compression and expansion of the first substrate 110.

Figure 9A depicts a first wave PW1; Figure 9B depicts a second wave PW2; and Figure 9C depicts a third wave PW3. Figure 9A-9C also show the propagation of a bond front BF in a left to right direction, which is indicative of the radially-outward propagation of the bond front BF. The waves PW1, PW2, PW3 may be pulse waves comprising a single (or a small number of), isolated disturbance(s) or displacement(s). The waves PW1, PW2, PW3 may cause displacement on only one side of the equilibrium.

Once generated, the waves PW1, PW2, PW3 propagate through the first substrate 110 at the speed of sound of the material from which the first substrate 110 is formed. For example, the first substrate 110 may be formed from silicon, and the speed of sound in the silicon may be around 2,200 m/s. The propagation of the waves PW1, PW2, PW3 may be much faster than the propagation of the bond front BF. Thus, the first wave PW1 depicted in Figure 9A may be a different wave to the second wave PW2 depicted in Figure 9B and the third wave PW3 depicted in Figure 9C. For example, the second wave PW2 may be a wave generated after the first wave PW1, and the third wave PW3 may be a wave generated after the second wave PW2. While Figure 9A indicates that the first wave PW1 is propagating in the radially outward direction, this is not essential. For example, in some embodiments, the waves PW1, PW2, PW3 may be generated in a radially outer portion of the first substrate 110 and propagate radially inwards.

Where the waves PW1, PW2, PW3 meet the bond front BF, the waves PW1, PW2, PW3 may interfere and/or interact with the bond front BF to modify the speed of propagation of the bond front.

For example, a wave involving displacement of the first substrate 110 away from the second substrate 120 (as is shown in Figures 9A to 9C) may pull the first substrate 110 away from the second substrate 120. This may slow down the propagation of the bond front BF.

As another example, a wave involving displacement of the first substrate 110 towards the second substrate 120 (i.e. the opposite to what is shown in Figures 9A to 9C) may push the first substrate 110 down onto the second substrate 120. This may speed up the propagation of the bond front.

In view of the above, by generating appropriate waves in the first substrate 110, the propagation of the bond front BF can be modified as required. For example, a method in accordance with the present disclosure may comprise identifying a spatial and/or temporal position of the bond front at which the bond front is relatively slow, and generating a wave (e.g. a wave in the first substrate 110) to interact with the bond front BF at the identified position, wherein the generated wave applies a force on the first substrate in the direction of the second substrate to increase a speed of propagation of the bond front at the identified position. Additionally or alternatively, the method may comprise identifying a spatial and/or temporal position of the bond front BF at which the bond front BF is relatively fast, and generating a wave (e.g. a wave in the first substrate 110) to interact with the bond front BF at the identified position, wherein the generated wave applies a force on the first substrate away from the second substrate to decrease a speed of propagation of the bond front at the identified position.

The pulse waves PW1, PW2, PW2 may be repeated as often as necessary to modify the propagation of the bond front as desired.

The wave described above may be generated in the first substrate 110 using any suitable means. As mentioned with reference to Figures 9A-9C, the wave may be generated in the first substrate 110 using the transducer 190. The transducer 190 may generate the wave in the first substrate 110 by applying a contact force to the rear surface 112 of the first substrate 110.

The means with which the wave is generated in the first substrate 110 for the second embodiment may be the same as, or similar to, the way in which vibrations are induced in the first substrate 110 for the method of the first embodiment. For example, the wave may be generated in the first substrate by applying a contact force to the rear surface 112 of the first substrate 110 using the pin 171, and/or other mechanical transducers configured to apply a contact force to the rear surface 112 of the first substrate 110.

The method of the second embodiment may comprise generating a plurality of waves in the first substrate 110, e.g. by applying a plurality of contact forces at different positions on the rear surface 112 of the first substrate 110. The plurality of contact forces may be applied using a bonding apparatus which is the same as, or similar to, the bonding apparatus described with reference to Figures 8A and 8B. For example, at least a portion of the plurality of contact forces may be applied radially outward of the radial centre of the rear surface 112 of the first substrate 110.

When a plurality of waves are generated in the first substrate 110, the plurality of waves may interfere with each other to generate a pressure profile across the first substrate 110. In this way, the plurality of transducers which generate the plurality of waves may operate as a phased array of transducers. The pressure profile may interact with the bond front to modify the speed of propagation of the bond front.

The pressure profile may vary as a function of position in the azimuthal direction. For examples, in some azimuthal portions of the first substrate 110, the pressure profile may be such that a force is exerted on the first substrate 110 in the direction of the second substrate 120, thus accelerating the propagation of the bond front. Additionally or alternatively, in other azimuthal portions of the first substrate 110, the pressure profile may be such that a force is exerted that pulls the first substrate 110 away from the second substrate 120, thus decelerating the propagation of the bond front. In this way, generating waves in the first substrate 110 may be able to improve the uniformity of the propagation of the bond front in the azimuthal direction, during the bonding process.

In the case that the waves are generated in a radially inner portion of the first substrate 110 and propagate radially outwards, the waves may be reflected at the circumference of the first substrate 110 and begin propagating radially inwards. This may be undesirable, because the radially-inwardly propagating waves may interfere with the bond front in a way which is not intended. Thus, dampers may be installed at the circumference of the first substrate 110 to reduce the extent to which waves are reflected. Additionally or alternatively, the impact of reflected waves may be modelled, and the driving of the transducers which generate the waves may be adjusted so as to account for the impact of the reflected waves.

The above discussion of the second embodiment has focused on the case where the wave is generated in the first substrate 110. However, a wave may (additionally or alternatively) be generated in the medium between the first substrate 110 and the second substrate 120. Such a wave may be a predominantly longitudinal wave with regions of compression (high pressure) and rarefaction (low pressure). A region of high pressure between the first and second substrates 110, 120 may oppose the coming together of the bonding surfaces 111, 121 of the first and second substrates 110, 120, thus reducing the speed of the propagation of the bond front. A region of low pressure between the first and second substrates 110, 120 may pull the first substrate 110 down onto the second substrate 120, thus increasing the speed of the propagation of the bond front. A wave may be generated in the medium between the first substrate 110 and the second substrate 120 using, for example, an acoustic transducer.

All of the methods of the present disclosure may be implemented in a feed-forward systems (e.g. where a predetermined mechanical deformation profile and/or predetermined wave(s) are generated by controlling the transducers) or in a feedback system (e.g. where a desired mechanical deformation profile and/or wave(s)-to-be-generated are determined during the bonding process based on aspects of the bonding process measured using one or more sensors, and this determined mechanical deformation profile and/or wave(s) are generated by controlling the transducers).

One signal on which a feedback system may be based is the moment of first contact between the bonding surface 111 of the first substrate 110 and the bonding surface 121 of the second substrate 120. This moment of first contact may be detected electrically, optically or acoustically.

A feedback system may also be based on the shape of the first substrate 110 and/or the second substrate 120 during the bonding process. The shape of the first substrate 110 and/or the second substrate 120 may be measured using an interferometer.

In the foregoing description, the case that the propagation of the bond front is manipulated by inducing vibrations and/or waves in the first substrate 110 has been explained. In the methods of the present disclosure, vibrations and/or waves may be induced in the second substrate 120 in order to modify the propagation of the bond front. This may in addition to, or instead of, inducing vibrations and/or waves in the first substrate 110. Thus, in some embodiments, vibrations and/or waves may be induced in the first substrate 110 and vibrations and/or waves may be induced in the second substrate 120. The vibrations and/or waves may be induced in the first substrate 110 may be the same as, or different to, the vibrations and/or waves induced in the second substrate 120.

The vibrations and/or waves may be induced in the second substrate 120 in substantially the same way as the way in which the vibrations and/or waves are induced in the first substrate 110. For example, the second clamp 180 may comprise one or more transducers for inducing vibrations and/or waves in the second substrate 120. Additionally or alternatively, vibrations and/or waves in and/or around the second substrate 120 may be induced by the same transducers which induce the vibrations and/or waves in and/or around the first substrate 110, e.g. by acoustic or mechanical coupling therebetween. For example, vibrations and/or waves induced in the first substrate 110 may propagate into the second substrate 120 by the contact between the bonding surface 111 of the first substrate 110 and the bonding surface 121 of the second substrate 120 after those surfaces have come into contact with one another during the bonding process.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. The methods of the invention may be carried out on a computer system located in the same system as the first clamp and second clamp, or may be remote from the first clamp and second clamp. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

Further embodiments of the invention are disclosed in the list of numbered clauses below:
1. A method of bonding a first substrate to a second substrate, the method comprising, while bringing a bonding surface of the first substrate into contact with a bonding surface of the second substrate, driving at least one vibrational mode of the first substrate to modify a speed of propagation of a bond front.
2. The method of clause 1, wherein the driving of the at least one vibrational mode of the first substrate comprises excitation of the first substrate at or near at least one eigenfrequency associated with the at least one vibrational mode.
3. The method of clause 1 or 2, wherein the driving of the at least one vibrational mode of the first substrate comprises applying at least one oscillatory contact force to the rear surface of the first substrate.
4. The method of any of the preceding clauses, further comprising applying, using an extensible pin, a force to a radial centre of the rear surface of the first substrate to initiate contact between the bonding surface of the first substrate and the bonding surface of the second substrate.
5. The method of clause 4, wherein the driving of the at least one vibrational mode of the first substrate comprises applying an oscillatory contact force to the rear surface of the first substrate using the extensible pin.
6. The method of any of the preceding clauses, wherein the driving of the at least one vibrational mode of the first substrate comprises applying a plurality of oscillatory contact forces to the rear surface of the first substrate.
7. The method of clause 6, wherein the plurality of oscillatory contact forces are applied at different positions on the rear surface of the first substrate.
8. The method of clause 7, wherein an arrangement of the positions at which the plurality of oscillatory contact forces are applied is symmetrical about the radial centre of the rear surface of the first substrate.
9. The method of clause 7 or 8, wherein a distance between a position at which an oscillatory contact force is applied and the radial centre of the rear surface of the first substrate is the same for each of at least a portion of the plurality of oscillatory contact forces.
10. The method of any of clauses 7 to 9, wherein the positions at which the at least a portion of the plurality of oscillatory contact forces are applied are vertices of a regular polygon, wherein a centre of the polygon is the radial centre of the rear surface of the first substrate, optionally wherein the polygon is a square, hexagon, or an octagon.
11. The method of any of clauses 6 to 10, wherein each of the plurality of oscillatory contact forces are applied with the same frequency and/or the same amplitude.
12. The method of any of clauses 6 to 10, wherein the plurality of oscillatory contact forces are applied with two or more frequencies to drive two or more vibration modes of the first substrate.
13. The method of any of clauses 6 to 11, wherein the plurality of oscillatory contact forces are applied with two or more amplitudes.
14. The method of any of clauses 1 to 4, wherein the driving of the at least one vibrational mode of the first substrate comprises acoustically driving the at least on vibrational mode of the first substrate.
15. A method of determining at least one operating frequency for driving at least one vibrational mode in a first substrate during a bonding process comprising bonding the first substrate to a second substrate, the method comprising: obtaining, as a function of position relative to the first substrate, the speed at which a bond front propagates during the bonding of the first substrate and the second substrate, or an indication thereof; selecting at least one vibrational mode of the first substrate based on the speed at which the bond front propagates as a function of position; and determining at least one operating frequency that drives the selected at least one vibrational mode in the first substrate.
16. The method of clause 15, wherein the selected at least one vibrational mode comprises antinodes in regions of the first substrate in which the speed of the bond front is relatively low, and nodes in regions of the first substrate in which the speed of the bond front is relatively high.
17. The method of clause 15 or 16, further comprising determining at least one vibrational mode of the first substrate and an eigenfrequency associated with the at least one vibrational mode of the first substrate.
18. The method of clause 17, wherein determining the at least one vibrational mode of the first substrate comprises modelling the first substrate using a finite element method.
19. The method of clause 17, wherein determining the at least one vibrational mode of the first substrate comprises performing practical experimentation on a test substrate which is similar to or the same as the first substrate.
20. The method of clause 19, wherein the practical experimentation comprises measuring a vibrational response of the test substrate when subjected to a disturbance, optionally wherein the measuring of the vibrational response is performed using an interferometer.
21. An apparatus for bonding a first substrate to a second substrate, the apparatus comprising a controller configured to cause the apparatus to perform the method of any of the preceding clauses.
22. A method of bonding a first substrate to a second substrate, the method comprising, while bringing a bonding surface of the first substrate into contact with a bonding surface of the second substrate, generating a wave in the first substrate or a medium around the first substrate, wherein the wave is configured to interact with a bond front to modify a speed of propagation of the bond front.
23. The method of clause 22, wherein the method comprises: identifying a spatial and/or temporal position of the bond front at which the bond front is relatively slow; and generating a wave to interact with the bond front at the identified position, wherein the generated wave applies a force on the first substrate in the direction of the second substrate to increase a speed of propagation of the bond front at the identified position.
24. The method of clause 22 or 23, wherein the method comprises: identifying a spatial and/or temporal position of the bond front at which the bond front is relatively fast; and generating a wave to interact with the bond front at the identified position, wherein the generated wave applies a force on the first substrate away from the second substrate to decrease a speed of propagation of the bond front at the identified position.
25. The method of any of clauses 22 to 24, wherein the wave is a wave in the first substrate.
26. The method of clause 25, wherein the generating of the wave comprises applying a contact force to the rear surface of the first substrate.
27. The method of any of clauses 22 to 26, further comprising applying, using an extensible pin, a force to a radial centre of the rear surface of the first substrate to initiate contact between the bonding surface of the first substrate and the bonding surface of the second substrate.
28. The method of clause 27, wherein the generating of the wave comprises applying a contact force to the rear surface of the first substrate using the extensible pin.
29. The method of any of clauses 22 to 28, wherein the method comprises generating a plurality of waves by applying a plurality of contact forces at different positions on the rear surface of the first substrate, wherein at least a portion of the plurality of contact forces are applied radially outward of the radial centre of the rear surface of the first substrate.
30. The method of clause 29, wherein the plurality of waves interfere with each other to generate a pressure profile across the first substrate, wherein the pressure profile interacts with the bond front to modify a speed of propagation of the bond front.
31. The method of clause 29 or 30, wherein the pressure profile varies as a function of position in the azimuthal direction.
32. The method of any of clauses 22 to 24, wherein the wave is a pressure wave in a medium between the first substrate and the second substrate.
33. An apparatus for bonding a first substrate to a second substrate, the apparatus comprising: a clamp for clamping the first substrate; an extensible pin configured to apply a force to a rear surface of the first substrate to cause a bonding surface of the first substrate to make contact with a bonding surface of the second substrate; and a plurality of mechanical transducers each configured to apply an oscillatory contact force to the first substrate to drive at least one vibration mode of the first substrate.
34. The apparatus of clause 33, wherein an arrangement of the plurality of mechanical transducers is symmetrical about the radial centre of clamp.
35. The apparatus of clause 33 or 34, wherein a distance between a mechanical transducer of the plurality of mechanical transducers and the radial centre of the rear surface of the first substrate is the same for each of at least a portion of the plurality of mechanical transducers.
36. The apparatus of any of clauses 33 to 35, wherein the plurality of mechanical transducers are positioned at the vertices of a polygon, wherein a centre of the polygon is the radial centre of the clamp, optionally wherein the polygon is a square, hexagon, or an octagon.
37. An apparatus for bonding a first substrate and a second substrate, the apparatus comprising: a clamp for clamping the first substrate; an extensible pin configured to apply a force to a rear surface of the first substrate to cause a bonding surface of the first substrate to make contact with a bonding surface of the second substrate; and an acoustic transducer, wherein the acoustic transducer is configured to induce a mechanical vibration in the first substrate acoustically, and/or to generate a pressure wave in a medium between the first substrate and the second substrate during the bonding of the first substrate and the second substrate.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of bonding a first substrate to a second substrate, the method comprising, while bringing a bonding surface of the first substrate into contact with a bonding surface of the second substrate, driving at least one vibrational mode of the first substrate to modify a speed of propagation of a bond front.

2. The method of claim 1, wherein the driving of the at least one vibrational mode of the first substrate comprises excitation of the first substrate at or near at least one eigenfrequency associated with the at least one vibrational mode.

3. The method of claim 1, wherein the driving of the at least one vibrational mode of the first substrate comprises applying at least one oscillatory contact force to the rear surface of the first substrate.

4. The method of claim 1, further comprising applying, using an extensible pin, a force to a radial centre of the rear surface of the first substrate to initiate contact between the bonding surface of the first substrate and the bonding surface of the second substrate.

5. The method of claim 4, wherein the driving of the at least one vibrational mode of the first substrate comprises applying an oscillatory contact force to the rear surface of the first substrate using the extensible pin.

6. The method of claim 1, wherein the driving of the at least one vibrational mode of the first substrate comprises applying a plurality of oscillatory contact forces to the rear surface of the first substrate.

7. The method of claim 6, wherein the plurality of oscillatory contact forces are applied at different positions on the rear surface of the first substrate.

8. The method of claim 7, wherein an arrangement of the positions at which the plurality of oscillatory contact forces are applied is symmetrical about the radial centre of the rear surface of the first substrate.

9. The method of claim 1, wherein the driving of the at least one vibrational mode of the first substrate comprises acoustically driving the at least on vibrational mode of the first substrate.

10. A method of determining at least one operating frequency for driving at least one vibrational mode in a first substrate during a bonding process comprising bonding the first substrate to a second substrate, the method comprising:
obtaining, as a function of position relative to the first substrate, the speed at which a bond front propagates during the bonding of the first substrate to the second substrate, or an indication thereof;
selecting at least one vibrational mode of the first substrate based on the speed at which the bond front propagates as a function of position; and
determining at least one operating frequency that drives the selected at least one vibrational mode in the first substrate.

11. The method of claim 10, wherein the selected at least one vibrational mode comprises antinodes in regions of the first substrate in which the speed of the bond front is relatively low, and nodes in regions of the first substrate in which the speed of the bond front is relatively high.

12. An apparatus for bonding a first substrate to a second substrate, the apparatus comprising:
a clamp for clamping the first substrate;
an extensible pin configured to apply a force to a rear surface of the first substrate to cause a bonding surface of the first substrate to make contact with a bonding surface of the second substrate; and
a plurality of mechanical transducers each configured to apply an oscillatory contact force to the first substrate to drive at least one vibration mode of the first substrate.

13. The apparatus of claim 12, wherein an arrangement of the plurality of mechanical transducers is symmetrical about the radial centre of the clamp.

14. The apparatus of claim 12, wherein a distance between a mechanical transducer of the plurality of mechanical transducers and the radial centre of the rear surface of the first substrate is the same for each of at least a portion of the plurality of mechanical transducers.

15. The apparatus of claim 12, wherein the plurality of mechanical transducers are positioned at the vertices of a polygon, wherein a centre of the polygon is the radial centre of the clamp.
